# EUROPEAN PATENT APPLICATION

(11) **EP 4 787 002 A1**
(43) Date of publication of application: **05.08.2026**
(21) Application number: 25275006.2
(22) Date of filing: 31.01.2025
(51) Int. Cl.: G01R 33/28, G01R 33/38, G01R 33/3815

(54) **COOLING SYSTEM FOR A MAGNETIC RESONANCE IMAGING APPARATUS**

(71) Applicant: Siemens Healthcare Limited, Camberley, Surrey GU15 3YL (GB)
(72) Inventor: BAMPTON, Adrian, OX14 4AX Abingdon (GB); QIAO, Liang, MK4 4PN Milton Keynes (GB)
(74) Representative: Siemens Healthineers Patent Attorneys

(57) **Abstract**

Described is a cooling system for a magnetic resonance imaging, MRI, apparatus, the cooling system comprising: a ramp down load configured to ramp down current flowing in an electromagnet of the MRI apparatus by dissipating electrical energy in the form of heat; and at least one cooling device configured to cool the ramp down load; wherein the at least one cooling device is configured to be powered by a voltage generated across at least a portion of the ramp down load when current flowing in the electromagnet is passed through the ramp down load. A magnetic resonance imaging, MRI, apparatus; a method of cooling a ramp down load of a magnetic resonance imaging, MRI, apparatus; and a method of testing a cooling system of a magnetic resonance imaging, MRI, apparatus are also described.

## Description

### Technical field

The present invention relates to a cooling system for a magnetic resonance imaging, MRI, apparatus.

### Background

A known MRI apparatus comprises an electromagnet of superconductive material. Current flowing through the superconductive material produces a magnetic field, which is then used in magnetic resonance imaging. The superconductive material is kept cool during operation of the MRI apparatus, for example using liquid helium, in order to maintain the superconductive properties of the superconductive material and hence maintain the magnetic field produced by the electromagnet.

There are certain circumstances when the electromagnet is ramped down, that is, the current flowing through the electromagnet is reduced, for example reduced to zero. Ramp down can be achieved by passing the current flowing through the superconductive material through a separate ramp down load. The ramp down load dissipates the electrical energy in the form of heat, in a controlled manner, over a period of time. Ramp down may be performed, for example, during a power outage when a system providing the cooling of the superconductive material of the electromagnet cannot function. This may be done in order to avoid quenching of the electromagnet during the power outage. Quenching is undesirable as recovering the superconductive electromagnet from a quenched state is difficult, and some components of the MRI apparatus may be damaged. As another example, ramp down may be performed in order to enable scheduled maintenance of the MRI apparatus.

In order to effectively dissipate heat from the ramp down load during a ramp down, the ramp down load may be coupled to a heat sink. However, in order to provide sufficient heat dissipation, relatively large heat sinks may need to be used, which can be costly and impractical in certain situations.

### Summary

A first aspect of the present invention provides a cooling system for a magnetic resonance imaging, MRI, apparatus, the cooling system comprising: a ramp down load configured to ramp down current flowing in an electromagnet of the MRI apparatus by dissipating electrical energy in the form of heat; and at least one cooling device configured to cool the ramp down load; wherein the at least one cooling device is configured to be powered by a voltage generated across at least a portion of the ramp down load when current flowing in the electromagnet is passed through the ramp down load.

Such cooling system can be used to safely ramp down the MRI apparatus, by cooling the ramp down load using a cooling device (e.g. at least one fan). This may ensure that the heat dissipated during the ramp down does not elevate a temperature of the MRI apparatus above a safe or regulatory limit. Traditionally, the ramp down load may be cooled using a heatsink which is of a sufficient size to have a heat capacity sufficient to absorb the heat dissipated during the ramp down. This could, especially for stronger electromagnets of about 3 Tesla or more that dissipate more heat during the ramp down, make the heat sink impracticably large. However, using the cooling device (e.g. at least one fan) to cool the ramp down load may reduce or remove the need to rely on large heat sinks to cool the ramp down load. For example, the cooling device may allow that a smaller heat sink may be used in order to dissipate the heat from the ramp down load during ramp down. This may reduce the cost, size and/or weight of the cooling system and hence the MRI apparatus.

Moreover, the cooling system according to the first aspect allows cooling even in power loss situations, as the energy to power the at least one cooling device of the cooling system is sourced from passing the current flowing in the electromagnet itself through the ramp down load. Therefore, for example, in cases where there is a power loss and the electromagnet is ramped down in order to avoid quenching of the electromagnet, the at least one cooling device can still be powered and hence the ramp down load can still be sufficiently cooled, without the need for large heat sinks. Accordingly, the heat sink may be of a smaller size than of an equivalent MRI without the cooling system according to the first aspect, or even entirely omitted, which in turn makes the MRI apparatus more compact and lightweight, thereby simplifying installation and reducing space requirements for the MRI apparatus.

Moreover, during ramp down for scheduled maintenance (or for other purposes) where mains power is available, the cooling system according to the first aspect can nevertheless be powered by the voltage generated across the ramp down load. Therefore, there is no need to configure the cooling system to provide an additional power supply for powering the cooling system, thereby removing cost, size, weight, and power consumption that would be associated with configuring the cooling system to be powered by the additional power supply.

Optionally, the at least one cooling device is at least one fan. This may provide a simple and effective means by which to cool the ramp down load.

Optionally, the at least one cooling device comprises a plurality of cooling devices (e.g. a plurality of fans). The plurality of cooling devices may provide an increased cooling capacity, and redundancy in an event of failure of one or more of the plurality of cooling devices. The number of cooling devices may be selected based on the electromagnet strength, and therefore the amount of heat to be dissipated during ramp down. A stronger MRI apparatus in terms of field may therefore have more cooling devices in its cooling system than a relatively weaker MRI apparatus, for example.

The cooling system may not be integral with the electromagnet in some examples, and/or may be configured to match a polarity of the electromagnet.

Optionally, the cooling system comprises a heat sink thermally coupled to the ramp down load, and the at least one cooling device is configured to cool the heat sink.

The heat sink may be located proximally to the ramp down load, and the at least one cooling device, such that the heat dissipated at the ramp down load is first absorbed by the heat sink which is in turn cooled by the at least one cooling device. The heat sink may be, for example, made of aluminium.

Optionally, the cooling system comprises at least one DC/DC voltage converter configured to invert the voltage generated across the ramp down load to power the at least one cooling device.

The voltage generated across the ramp down load is negative voltage while the voltage used to power the at least one cooling device may be positive. The DC/DC voltage converter can invert such negative voltage generated across the ramp down load into a positive voltage to power the at least one cooling device. The DC/DC voltage converter may additionally be a voltage booster, configured to increase the magnitude of the voltage to a magnitude used by the at least one cooling device. The cooling system may comprise two or more such DC/DC voltage converters, optionally the number of such DC/DC voltage converters is equal to the number of cooling devices.

Optionally, the ramp down load comprises at least one diode configured to, while the current is passed through the at least one diode, dissipate electrical energy in the form of heat and generate the voltage.

The at least one diode of the ramp down load only permits current flow in one direction. Such configuration of the ramp down load serves, in addition to generating the voltage and dissipating the heat, as surge protection during the ramp down because a voltage buildup in a superconductive switch of the electromagnet is reduced.

Optionally, the ramp down load comprises a plurality of diodes. Optionally, an orientation of the at least one diode direction is dictated by a polarity of the electromagnet.

Optionally, the cooling system comprises a monitoring apparatus configured to test the cooling system when no current is being passed through the ramp down load, and an indicator configured to indicate a result of a test of the cooling system undertaken by the monitoring apparatus.

Such a monitoring apparatus may be used to test whether or not the cooling apparatus is functioning when the MRI apparatus is in normal operation (i.e. not during the ramp down). The monitoring system may, for example, output a simple positive or negative indication, for example via a green or red light, or an auditory indication to the user. The monitoring apparatus may be configured to test the cooling apparatus at regular, predetermined intervals such as once a day or once a week, for example, and/or may be triggerable on demand by a user via an interface. If it is determined that the cooling system is not functioning correctly, the indication may prompt an engineer to service the cooling system.

Optionally, the monitoring apparatus comprises: at least one of: a cooling device (e.g. fan) speed monitor configured to monitor a speed of the at least one cooling device (e.g. fan), and a voltage monitor configured to monitor a voltage supplied to the at least one cooling device; and a diagnostic unit configured to receive and evaluate an output from the voltage monitor and/or the cooling device speed monitor to diagnose operation of the at least one cooling device. Such a monitoring apparatus may output more detailed diagnostics of the cooling system, such as, for example, if more than one cooling device is present, an indication of whether or not each cooling device is working.

Optionally, the monitoring apparatus is configured to power the at least one cooling device using a different voltage source than the ramp down load.

The monitoring apparatus may thereby test the at least one cooling device without a need to pass current through the ramp down load. The different voltage source may, for example, be a mains power supply or a local power source such as a power source associated with a controller of the cooling system.

Optionally, the monitoring apparatus comprises a voltage converter to convert a positive voltage from the different voltage source to a negative voltage that simulates the voltage generated across the ramp down load.

This enables the whole cooling system to be tested. Specifically, the simulated negative voltage is provided to the at least one DC/DC voltage converter, which will then convert the voltage to power the at least one cooling device. This tests whether both the DC/DC voltage converter and the at least one cooling device are working.

Optionally, the at least one cooling device comprises a plurality of cooling devices, and the monitoring apparatus is configured to test sequentially each of the plurality of cooling devices (e.g. fans).

Thereby each of the plurality of cooling devices can be tested using a relatively small power source, for example from the different voltage source, negating a need for a larger power source to be provided for the monitoring apparatus.

Optionally, the cooling system comprises a controller configured to control a switch that when opened causes the current flowing in the electromagnet to pass through the ramp down load, thereby ramping down the current flowing in the electromagnet.

Such a controller can initiate the ramp down of the electromagnet, which will, in turn, cause the cooling system to operate automatically, when needed (e.g. during power loss). The controller may also be configured to operate and/or power the monitoring apparatus for testing the cooling system. The controller may be distinct from or be a part of the overall controller of the MRI apparatus.

A second aspect of the present invention provides a magnetic resonance imaging, MRI, apparatus comprising the cooling system according to the first aspect.

Optionally, the MRI apparatus is a dry type MRI apparatus. A dry MRI apparatus has no, or only a relatively small amount of, liquid helium in its electromagnet cooling apparatus, compared to a traditional MRI apparatus. Such dry MRI apparatuses may be more susceptible to quenching during a power outage, as the electromagnet cooling apparatus does not have as significant a heat capacity as a traditional MRI apparatus during power outage. Therefore, having a safe cooling system for ramp down is highly beneficial to prevent unsafe overheating and/or quench of the electromagnet.

A third aspect of the present invention provides a method of cooling a ramp down load of a magnetic resonance imaging, MRI, apparatus, the ramp down load being configured to ramp down current flowing in an electromagnet of the MRI apparatus by dissipating electrical energy in the form of heat; the method comprising: passing current flowing in the electromagnet through the ramp down load; using a voltage generated across the ramp down load when the current flowing in the electromagnet is passed through the ramp down load to power at least one cooling device; and using the at least one cooling device to cool the ramp down load. The at least one cooling device may be at least one fan.

Optionally, the method further comprises testing the at least one cooling device when no current is being passed through the ramp down load, wherein the testing comprises: converting a positive voltage, from a different voltage source than the ramp down load, to a negative voltage that simulates the voltage generated across the ramp down load; and using the negative voltage to power the at least one cooling device during testing.

Optionally, there are a plurality of cooling devices and testing the plurality of cooling devices comprises using the negative voltage to sequentially power each cooling device during testing.

A fourth aspect of the present invention provides a method of testing a cooling system of a magnetic resonance imaging, MRI, apparatus comprising: drawing a positive voltage from a power source; converting the positive voltage to a negative voltage that simulates a voltage generated across at least a portion of a ramp down load of the cooling system during a ramp down; using the negative voltage to power at least one cooling device of the cooling system during testing.

Optionally, there are a plurality of cooling devices, and wherein the method comprises: using the negative voltage to sequentially power each cooling device during testing.

Optionally, the method comprises: for each of the at least one cooling devices, while the cooling device is being powered, monitoring a voltage supplied to the cooling device and/or a speed of the cooling device (e.g. fan); and determining a status of the cooling system based on the monitoring, for each of the at least one cooling devices, of the voltage supplied to the cooling device and/or the speed of the cooling device.

Optionally, the determining the status of the cooling system comprises determining, for each of the at least one cooling devices, whether the monitored voltage supplied to the cooling device and/or the speed of the cooling device are within respective predefined limits.

Optionally, the determining the status of the cooling system comprises: in response to a determination that, for each of the at least one cooling devices, the monitored voltage supplied to the cooling device and/or the speed of the cooling device are within the respective predefined limits, determining a pass status for the cooling system;

Optionally, the determining the status of the cooling system comprises: in response to a determination that, for one or more of the at least one cooling devices, the monitored voltage supplied to the cooling device and/or the speed of the cooling device are not within the respective predefined limits, determining a fail status for the cooling system.

Optionally, the method comprises indicating the determined status of the cooling system; wherein indicating the determined status comprises indicating either a pass status, wherein the cooling system does not require maintenance, or a fail status, wherein the cooling system requires maintenance.

Optionally, there are a plurality of cooling devices, and wherein indicating the determined status of the cooling system comprises indicating, for each of the cooling devices, either a pass status, wherein the cooling device of the plurality of cooling devices does not require maintenance, or a fail status, wherein the cooling device of the plurality of cooling devices requires maintenance.

### Brief Description of the Drawings

Figure 1 is a schematic diagram illustrating an MRI apparatus according to an example;
Figure 2 is a schematic diagram illustrating a cooling system according to a first example;
Figure 3 is a schematic diagram illustrating a cooling system according to a second example;
Figure 4 is a flow diagram illustrating a method of cooling a ramp down load of an MRI apparatus according to an example; and
Figure 5 is a flow diagram illustrating a method of testing a cooling system of an MRI apparatus according to an example.

### Detailed Description

An MRI apparatus comprises a superconductive electromagnet shaped in an annular ring such that an inner cavity is defined wherein imaging can take place, for example in a medical setting.

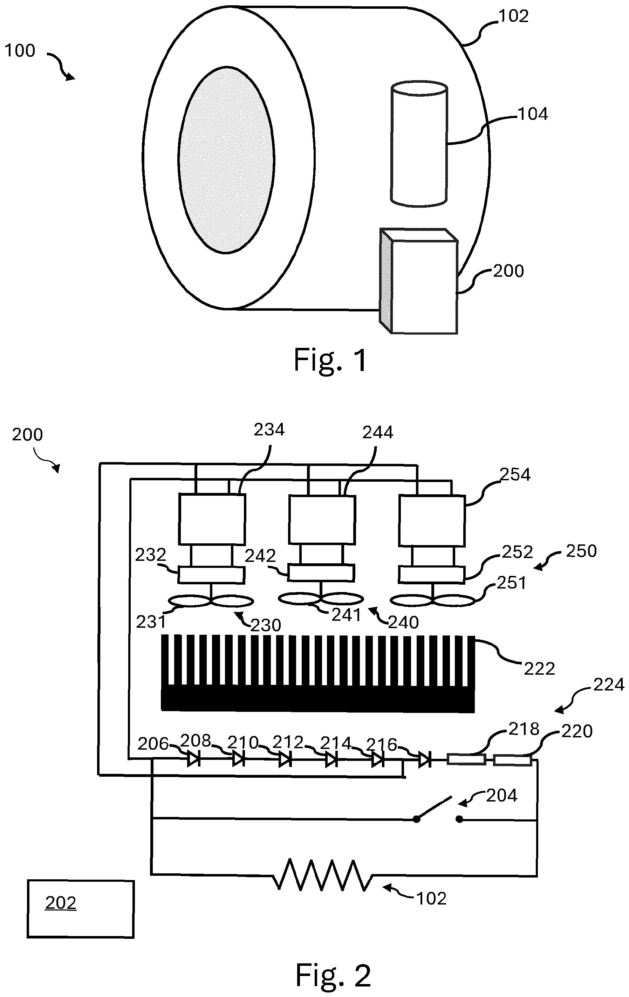

A schematic depiction of an MRI apparatus in accordance with an example of the present invention is shown in Figure 1. The MRI apparatus 100 comprises an electromagnet 102, an electromagnet cooling mechanism 104 and a cooling system 200.

In examples, the MRI apparatus 100 is a dry-type MRI apparatus, therefore the electromagnet cooling mechanism 104 comprises a relatively small reservoir of coolant, of about 1 litre of liquid helium in gas equivalent. The electromagnet cooling mechanism 104 is for cooling the electromagnet 102 during normal operation, to keep the electromagnet 102 at superconductive temperature. The electromagnet cooling mechanism 104 is powered by mains electricity.

The cooling system 200 provides cooling of a ramp down load during ramp down of the electromagnet 102, that is, when the current is being removed from the electromagnet 102. For example, ramp down of the electromagnet 102 may be performed in order to avoid quenching of the superconducting electromagnet 201. Quenching may occur when the temperature of the superconducting electromagnet 102 rises above the critical temperature, leading to the superconducting electromagnet 102 presenting a resistance to the current flowing therein, which in turn leads to further, and rapid, heating of the electromagnet 102. Such quench is undesirable, as it may be difficult to recover the electromagnet 102 from a quenched state, and/or it damaging to the electromagnet 102 and its electronics. The ramp down is specifically a gradual process, in contrast to a quench which is a rapid process. The ramp down is performed by passing current flowing through the electromagnet 102 through a ramp down load that is thermally separated from the electromagnet 102.

The cooling system 200 is shown in detail, schematically, in Figure 2. The cooling system 200 is electrically connected to the electromagnet 102.

The cooling system 200 comprises a ramp down load 224. In this example, the ramp down load 224 comprises six diodes 206, 208, 210, 212, 214, 216 and two resistors 218, 220, all arranged in series with one another. The two resistors 218,220 represent lead impedances of connecting parts, for example electrical connections to the electromagnet 102 . The ramp down load 224 is connected in series with the electromagnet 102 such that a current may pass from the electromagnet 102 through the diodes 206-216 in sequence. In this example, the cooling system comprises a controller 202 and a superconductive switch 204. The superconductive switch 204 is connected in parallel with the ramp down load 224. When the superconductive switch 204 is closed, current flows in a loop through the electromagnet 102 and the superconductive switch 204. The superconductive switch 204 and electromagnet 102 offer no resistance to the current. In this state, no current flows through the ramp down load 224. When ramp down of the current is required, the controller 202 controls the superconductive switch 204 to open (as shown in Figure 2). In this state, the current is forced to flow through the ramp down load 224, thereby ramping down the current flowing through the electromagnet 102.

The cooling system 200 further comprises a heat sink 222, arranged near and along the ramp down load 224, and specifically the six diodes 206-216, to absorb heat dissipated by the ramp down load 224 when current is passing through the ramp down load 224.

The cooling system 200 further comprises a first fan 230 comprising first set of blades 231, and a first fan drive 232 configured to drive the first set of blades 231 when powered. The first fan drive 232 is electrically connected to a first boost inverter 234, which in turn is electrically connected across a portion of the ramp down load 224. Specifically, in this example, the first boost inverter 234 is connected across five 206-214 of the six diodes 206-216. The first boost inverter 234 is configured to, when current is flowing through the six diodes 206-216, invert and boost a voltage generated across the five 206-214 of the six diodes 206-216. In this example, each of the five 206-214 of the six diodes 206-216 generates -1V when current (e.g. 500A) is passed through them. Accordingly, when current (e.g. 500A) from the electromagnet 102 is passed through the ramp down load 224, a voltage of -5V is generated across the five 206-214 of the six diodes 206-216. In examples, the first boost inverter 234 may be connected across more or fewer than five diodes, and hence may be provided with a correspondingly lower or higher magnitude voltage, respectively. For example, the boost inverter 234 may be configured to operate with an input voltage of between -4V to -7V. Accordingly, in this example where -1V is generated across each diode, the boost inventor 234 may be connected across four to six of the diodes 206-216. Other examples are possible. In the present example, the first boost inverter 234 is configured to covert the -5V to +12V, thereby inverting and boosting the voltage. The +12V is then provided to the first fan drive 232 to drive the first set of blades 231. The first set of blades 230 is arranged near the heat sink 222 such that when the first fan 230 is powered, the first set of blades 231 causes air to flow over the heat sink 222, thereby increasing the speed at which heat is dissipated from the heat sink 222. Accordingly, the heat sink 222 is cooled by the first fan 230.

The cooling system 200 further comprises a second fan 240 comprising a second set of blades 241, and a second fan drive 242 configured to drive the second set of blades 241 when powered. The second fan drive 242 is electrically connected to a second boost inverter 244, which in turn is electrically connected across a portion of the ramp down load 224. Specifically, in this example, as for the first boost inverter 234, the second boost inverter 244 is connected across five 206-214 of the six diodes 206-216. The second boost inverter 244 is configured to, when current is flowing through the six diodes 206-216, invert and boost a voltage generated across the five 206-214 of the six diodes 206-216. In this example, each of the five of the six diodes 206-216 generates -1V when current (e.g. 500 A) is passed through them, therefore about -5V in total across the five 206-214 of the six diodes 206-216. As described above, other examples are possible. In this example, the second boost inverter 244 is configured to covert the -5V to +12V, thereby inverting and boosting the voltage. The +12V is then provided to the second fan drive 242 to drive the second set of blades 241. The second set of blades 241 is arranged near the heat sink 222 such that when the second fan 240 is powered, the second set of blades 241 causes air to flow over the heat sink 222, thereby increasing the speed at which heat is dissipated from the heat sink 222. Accordingly, the heat sink 222 is cooled by the second fan 240.

The cooling system 200 further comprises a third fan 250 comprising a third set of blades 251, and a third fan drive 252 configured to drive the third set of blades 251 when powered. The third fan drive 252 is electrically connected to a third boost inverter 254, which in turn is electrically connected across a portion of the ramp down load 224. Specifically, in this example, the third boost inverter 254 is connected across five 206-214 of the six diodes 206-216. The third boost inverter 254 is configured to, when current is flowing through the six diodes 206-216, invert and boost a voltage generated across the five 206-214 of the six diodes 206-216. In this example, each of the five 206-214 of the six diodes 206-216 generates -1V when current (e.g. 500 A) is passed through them, therefore about -5V in total across the five 206-214 of the six diodes 206-216. As described above, other examples are possible. In this example, the third boost inverter 254 is configured to covert the -5V to +12V, thereby inverting and boosting the voltage. The +12V is then provided to the third fan drive 252 to drive the third set of blades 251. The third set of blades 251 is arranged near the heat sink 222 such that when the third fan is powered the third set of blades 251 causes air to flow over the heat sink 222, thereby increasing the speed at which heat is dissipated from the heat sink 222. Accordingly, the heat sink 222 is cooled by the third fan 250.

Therefore, when the current is flowing through the ramp down load 224, the first fan 230, the second fan 240 and the third fan 250 are operated, powered by the voltage generated across the five 206-214 of the six diodes 206-216, to cool the heat sink 222.

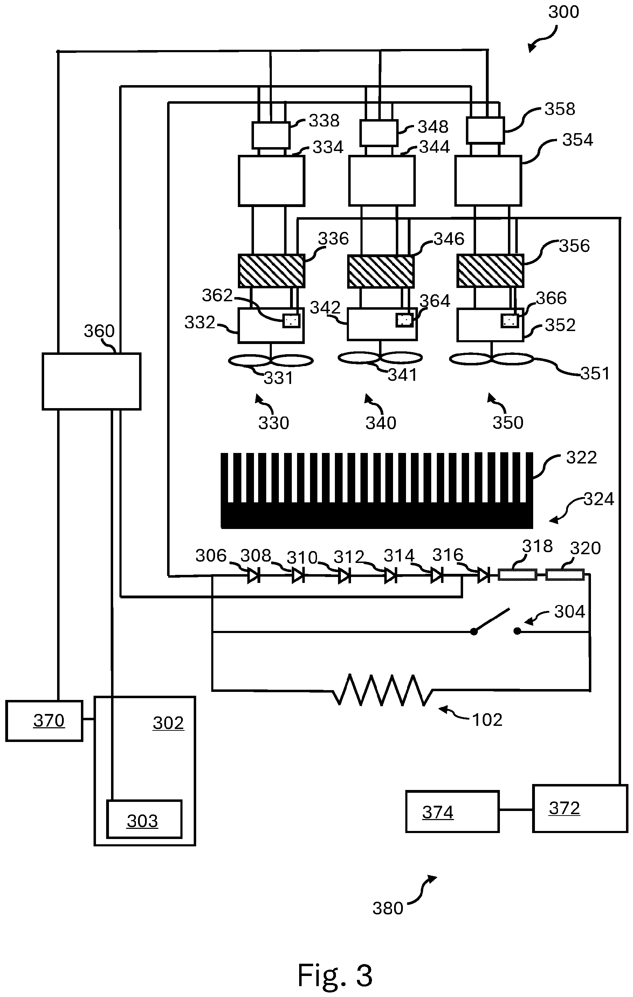

A cooling system 300 according to a second example is shown in Figure 3.

The cooling system 300, similarly to the previously described cooling system 200, is electrically connected to the electromagnet 102.

The cooling system 300 comprises a ramp down load 324. In this example, the ramp down load 324 comprises six diodes 306, 308, 310, 312, 314, 316 and two resistors 318, 320, all arranged in series with one another. As above, the two resistors 318, 320 represent lead impedances of connecting parts, for example electrical connections to the electromagnet 102. The ramp down load 324 is connected in series with the electromagnet 102 such that a current may pass from the electromagnet 102 through the diodes 306-316 in sequence. In this example, the cooling system comprises a controller 302 and a superconductive switch 304. The superconductive switch 304 is connected in parallel with the ramp down load 324. When the superconductive switch 304 is closed, current flows in a loop through the electromagnet 102 and the superconductive switch 304. The superconductive switch 304 and electromagnet 302 offer no resistance to the current. In this state, no current flows through the ramp down load 324. When ramp down of the current is required, the controller 302 controls the superconductive switch 304 to open (as shown in Figure 3). In this state, the current is forced to flow through the ramp down load 324, thereby ramping down the current flowing through the electromagnet 102. The cooling system 300 further comprises a heat sink 322, arranged along the six diodes 306-316 to absorb heat dissipated at the six diodes 306-316 when current is passing through the six diodes 306-316.

The cooling system 300 further comprises a first fan 330 comprising a first set of blades 331, and a first fan drive 332 configured to drive the first set of blades 331 when powered. The first fan drive 332 is electrically connected to a first boost inverter 334, which in turn is electrically connected across a portion of the ramp down load 324. Specifically, in this example, the first boost inverter 334 is connected across five of the six diodes 306-316. The first boost inverter 334 is configured to, when current is flowing through the six diodes 306-316, invert and boost a voltage generated across the five 306-314 of the six diodes 306-316. In this example, each of the five 306-314 of the six diodes 306-316 generates -1V when current (e.g. 500A) is passed through them. As above, other examples are possible. In this example, the first boost inverter 334 is configured to covert the -5V to +12V, thereby inverting and boosting the voltage. The +12V is then provided to the first fan drive 332 to drive the first set of blades 331. The first set of blades 331 is arranged near the heat sink 322 such that when the first fan 330 is powered the first set of blades 331 causes air to flow over the heat sink 322, thereby increasing the speed at which heat is dissipated from the heat sink 322. Accordingly, the heat sink 322 is cooled by the first fan 330.

The cooling system 300 comprises a monitoring apparatus 380. The monitoring apparatus 380 comprises a first switch 338, connected between the first boost inverter 334 and the ramp down load 324. The first switch 338 may either be closed, permitting current flow to the first boost inverter 334, or opened, not permitting current flow to the first boost inverter 334. The monitoring apparatus 380 comprises a first voltage monitor 336, arranged between the first boost inverter 334 and the first fan drive 332. The first voltage monitor 336 is configured to measure voltage input to the first fan drive 332.

The cooling system 300 further comprises a second fan 340 comprising a second set of blades 341, and a second fan drive 342 configured to drive the second set of blades 341 when powered. The second fan drive 342 is electrically connected to a second boost inverter 344, which in turn is electrically connected across a portion of the ramp down load 324. Specifically, in this example, the second boost inverter 344 is connected across five 306-314 of the six diodes 306-316. The second boost inverter 344 is configured to, when current is flowing through the six diodes 306-316, invert and boost a voltage generated across the five 306-314 of the six diodes 306-316. In this example, each of the five 306-314 of the six diodes 306-316 generates - 1V when current (e.g. 500A) is passed through them. As above, other examples are possible. In this example, the second boost inverter 344 is configured to covert the -5V to +12V, thereby inverting and boosting the voltage. The +12V is then provided to the second fan drive 342 to drive the second set of blades 341. The second set of blades 341 is arranged near the heat sink 322 such that when the second fan 340 is powered, the second set of blades 341 causes air to flow over the heat sink 322, thereby increasing the speed at which heat is dissipated from the heat sink 322. Accordingly, the heat sink 322 is cooled by the second fan 340.

The monitoring apparatus 380 comprises a second switch 348, connected between the second boost inverter 344 and the ramp down load 324. The second switch 348 may either be closed, permitting current flow to the second boost inverter 344, or opened, not permitting current flow to the second boost inverter 344. The monitoring apparatus 380 comprises a second voltage monitor 346, arranged between the second boost inverter 344 and the second fan drive 342. The second voltage monitor 346 is configured to measure voltage input to the second fan drive 342.

The cooling system 300 further comprises a third fan 350 comprising a third set of blades 351, and a third fan drive 352 configured to drive the third set of blades 351 when powered. The third fan drive 352 is electrically connected to a third boost inverter 354, which in turn is electrically connected across a portion of the ramp down load 324. Specifically, in this example, the third boost inverter 354 is connected across five of the six diodes 306-316. The third boost inverter 354 is configured to, when current is flowing through the six diodes 306-316, invert and boost a voltage generated across the five 306-314 of the six diodes 306-316. In this example, each of the five 306-314 of the six diodes 306-316 generates -1V when current (e.g. 500A) is passed through them. As above, other examples are possible. In this example, the third boost inverter 354 is configured to covert the -5V to +12V, thereby inverting and boosting the voltage. The +12V is then provided to the third fan drive 352 to drive the third set of blades 351. The third set of blades 351 is arranged near the heat sink 322 such that when the third fan 350 is powered, the third set of blades 351 causes air to be blown over the heat sink 322, thereby increasing the speed at which heat is dissipated from the heat sink 322. Accordingly, the heat sink 222 is cooled by the third fan 350.

The monitoring apparatus 380 comprises a third switch 348, connected between the third boost inverter 354 and the ramp down load 324. The third switch 358 may either be closed, permitting current flow to the third boost inverter 354, or opened, not permitting current flow to the third boost inverter 354. The monitoring apparatus 380 comprises a third voltage monitor 356, arranged between the third boost inverter 354 and the third fan drive 352. The third voltage monitor 356 is configured to measure voltage input to the third fan drive 352.

Therefore, when the current is flowing through the six diodes 306-316, if the first switch 338, the second switch 348 and the third switch 358 are opened, the first fan 330, the second fan 340 and the third fan 350 are operated, powered by the voltage generated across the five 306-314 of the six diodes 306-316, and cool the heat sink 322.

The monitoring apparatus 380 further comprises a first fan speed monitor 362, a second fan speed monitor 364 and a third fan speed monitor 366, each configured to measure a speed of rotation of the first fan 330, the second fan 340 and the third fan 350, respectively.

The monitoring apparatus 380 comprises a voltage converter 360 configured to convert a voltage sourced from a power source 303 of the controller 302 to simulate the voltage generated across the five 306-314 of the six diodes 306-316 when current is passed through the ramp down load 324. This can be used to test the fans when ramp down is not occurring. For example, the power source 303 may supply a positive voltage of +12V to the voltage converter 360. The voltage converter 360 may convert this a negative voltage of -5V in order to simulate the voltage that would be generated across the ramp down load during ramp down. The cooling system 300 also comprises a timer 370, operable by the controller 302, to sequentially open and, after a predetermined period, close, the first switch 338, the second switch 348 and the third switch 358.

The monitoring apparatus 380 comprises a diagnostic unit 372, configured to collect and evaluate a signal and/or data generated by the first fan speed monitor 362, the second fan speed monitor 364, the third fan speed monitor 366, the first voltage monitor 336, the second voltage monitor 346 and the third voltage monitor 356. An indicator 374 is connected to the diagnostic unit 372, and configured to display an output from the diagnostic unit 372.

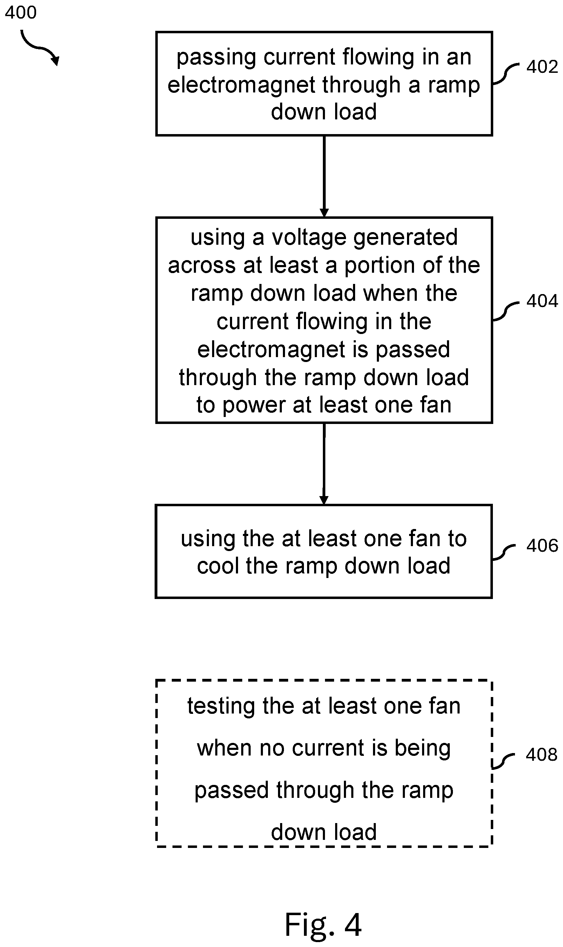

An example method 400 of cooling a ramp down load of an MRI apparatus is schematically depicted in Figure 4. The ramp down load may, for example, be the ramp down load 224 of the cooling system 200 according to the first example, or the ramp down load 324 of the cooling system 300 according to the second example.

The method 400 comprises passing 402 current flowing in the electromagnet through the ramp down load. In the first example cooling system 200, the current passes through the six diodes 206-216 and the two resistors 218, 220 when a ramp down is initiated by the controller 202. The controller 202 is, in this example, configured to initiate the ramp down when the electromagnet cooling system 104 is not powered for a predetermined period of time (i.e. in an event of a power loss) or on demand by a user. When the current is passed through a ramp down load, such as the ramp down load 224, heat is dissipated and a voltage is generated across the ramp down load.

The method 400 further comprises using 404 the voltage generated at across at least a portion of the ramp down load when the current flowing in the electromagnet is passed through the ramp down load to power at least one fan. In the cooling system 200 according to the first example, the voltage generated across the five 206-214 of the six diodes 206-216 of the ramp down load 224 is used to power the first fan 230, the second fan 240 and the third fan 250 of the cooling system 200. In this example, the voltage generated across the at least a portion of the ramp down load 224 is also converted and boosted by the first voltage boost inverter 234, the second voltage boost inverter 244 and the third voltage boost inverter 254, prior to powering the respective first, second and third fan drives 232,242,252 to drive the respective first, second and third sets of blades 230,240,250.

The method 400 further comprises using 406 the at least one fan to cool the ramp down load. In the first example cooling system 200, the ramp down load 224 dissipates heat which is absorbed by the heatsink 222. The heatsink 222 is in turn cooled by the respective first, second and third fans 230,240,250.

In examples, the method 400 further comprises testing 408 the at least one fan when no current is being passed through the ramp down load, wherein the testing comprises: converting a positive voltage, from a different voltage source than the ramp down load, to a negative voltage that simulates the voltage generated across the ramp down load; and using the negative voltage to power the at least one fan during testing. In the second example cooling system 300, when no current is being passed through the ramp down load 324 (i.e. not during a ramp down), the controller 302 may use the controller power source 303 to power the respective first, second and third fan drives 332, 342, 352 by converting the voltage supplied from the controller power source 303 to an appropriate voltage by the voltage converter 360. In this manner, the respective first, second and third fans 330, 340, 350 experience the same voltage they would experience during a ramp down event, and may be tested.

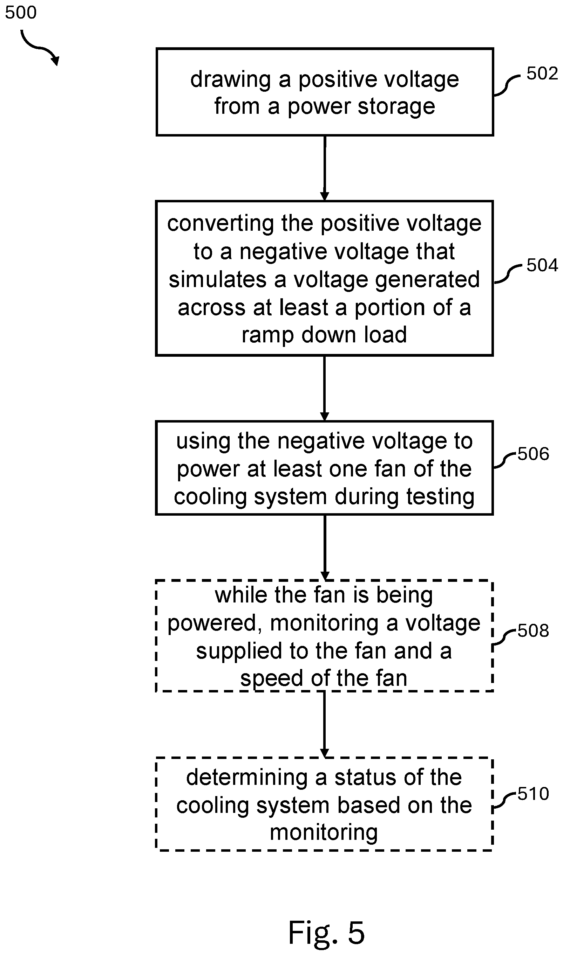

An example method 500 of testing a cooling system of an MRI apparatus is shown in Figure 5. In this example, the method 500 is a method of testing the cooling system 300 according to the second example, using the monitoring apparatus 380.

The method 500 comprises drawing 502 a positive voltage from a power source. In this example, the positive voltage is drawn from the controller power source 303.

The method 500 comprises converting 504 the positive voltage to a negative voltage that simulates a voltage generated across at least a portion of a ramp down load of the cooling system during a ramp down. In this example, the positive voltage from the controller power source 303 is converted by the voltage converter 360 to a negative voltage that matches the voltage produced across the at least a portion of the ramp down load 324 (e.g. the five 206-214 of the six diodes 206-216 of the ramp down load 224) during a ramp down.

The method 500 further comprises using 506 the negative voltage to power at least one fan of the cooling system during testing. In this example, the negative voltage, previously converted and boosted by the voltage converter 360 at the step of converting 504 the positive voltage, is used to power each of the respective first, second and third fan drives 332,342,352 of the respective first, second and third fans 330,340,350 of the cooling system 300.

The respective first, second and third fans 330,340,350 are powered sequentially by the controller 302 using the timer 370 and the respective first, second and third switches 338, 348, 358. During the sequential powering, the respective first, second and third fan drives 332, 342, 352 are powered one by one, i.e. the first fan drive 332 is powered for a first period of time, as the first switch 338 is held closed, while the second fan drive 342 and the third fan drive 352 are not powered, as the second and third switches 348, 358 are held opened. Then, during a second period of time following the first period of time, the second fan drive 342 is powered, as the second switch 348 is held closed, while the first fan drive 332 and the third fan drive 352 are not powered, as the first and third switches 338, 358 are held opened. Then, during a third period of time following the second period of time, the third fan drive 352 is powered, as the third switch 358 is held closed, while the first fan drive 332 and the second fan drive 342 are not powered, as the first and second switches 338, 348 are held opened. The first, second, and third periods of time have, in this example, the same duration of approximately one minute. Such time periods are dictated by the timer 370, based on a programming of the timer 370. The method 500 comprises, for each of the at least one fans, while the fan is being powered, monitoring 508 a voltage supplied to the fan and a speed of the fan. In this example, each of the respective first, second and third fans 330, 340, 350 is provided with a respective first, second, and third voltage monitor 336, 346 and 356 which gather and transmit to the diagnostic unit 372 data of voltage supplied to the respective first, second and third fan drives 332, 342, 352. The fan speed monitors 362, 364, 366 similarly collect and transmit to the diagnostic unit 372 the fan speed signal and/or data of each of the respective fans.

The method 500 comprises determining 510 a status of the cooling system based on the monitoring, for each of the at least one fans, of the voltage supplied to the fan and the speed of the fan. In this example, the diagnostic unit 372 evaluates the signal and/or data received from the speed monitors 362, 364, 366 and the voltage monitors 336, 346, 356 to determine for each of the respective fans a pass or fail status, as well as an overall status of the cooling system 300. Thereby, in this example, the method 500 determines both an overall status of the cooling system 300 as well as individually for each of the respective fans. For example, the determination may be that the overall cooling system 300 is ready to be used but the second fan in particular is not working (the speed monitor 364 determined no speed, or speed below a predetermined limit). In another example determination, one of the fans may not be working (speed monitor detects no speed, or speed below a predetermined limit) but there is also an issue with the power supply to that fan (the voltage monitor detects no input voltage, or voltage below a predetermined limit) therefore the problem is not with the fan but with another component of the cooling system 300, such as one of the voltage boost converters. If the number of fans not working, based on a predetermined criteria, reaches a predetermined number, for example two out of three fans not working, the overall system may be determined as having failed the test, and maintenance is required. In some examples, the diagnostic unit 372 may apply logic that accumulates a pass/fail determination for the voltage and fan speed for each fan to determine a pass/fail determination for each fan, and then accumulates the pass/fail determination for each of the plurality of fans to determine a pass/fail determination of the cooling system 300 as a whole. For example, if the signal and/or data received from the speed monitors 362, 364, 366 and the voltage monitors 336, 346, 356 indicates that the voltage supplied to any one of the fan drives 332, 342, 352 is outside a predetermined range or indicates that the fan speed of any one of the fan drives 332, 342, 352 is outside a predetermined range, then the diagnostic unit may determine a fail status for the cooling system 300 as a whole, and indicate that maintenance is required.

The determining 510 the status is implemented, in this example, by a diagnostic unit consisting of circuitry elements. For example, the determination logic according to any one of the above examples may be implemented in circuitry, using analogue signals. This is to reduce any radio frequency signals potentially influencing the imaging function of the MRI apparatus. In alternative examples however, the diagnostic unit may be a computer or a microprocessor.

The indicator 374 then indicates the result of the determining 510 the status, via a visual interface, such as the indicator 374, to a user.

In alternative examples of the present invention, the following features may be modified or omitted as described.

In cooling apparatuses according to alternative examples of the present invention, the number of fans and the respective associated drives may be different than previously described, for example there may be cooling systems with one or two or more than three sets of fans and fan drives. The number of fans may be chosen in part based on a desired redundancy of the cooling system, and/or in part based on a desired cooling capacity, for example more powerful MRI apparatus may be provided with a more powerful cooling system comprising a greater number of fans.

Similarly, a load present in the ramp down load may differ from the previously described examples, for example by providing different load type or by modifying the number of diodes, such as more or fewer than six diodes. Similarly, the portion of the ramp down load across which the voltage is generated to power the fans may be a different portion than the examples described above. The load of the ramp down load may be tailored to the power dissipation rate needed to safely ramp down a particular MRI apparatus, for example more powerful MRI apparatuses may be provided with greater ramp down loads to more quickly dissipate the current from the electromagnets. Similarly, the portion of the ramp down load across which the voltage is generated to power the fans may be tailored to the heat dissipation rate (e.g. the number and/or power of the fans) needed to cool the particular ramp down load.

The heatsink of the cooling system may be modified or entirely omitted, in which case the fan or fans are configured to cool the ramp down load directly, in alternative examples. The size of the heatsink will determine its heat capacity, which may be tailored to a heat dissipation rate of the ramp down load of each example as required.

The monitoring apparatus may be simplified, for example only configured for outputting a simpler pass/fail status of the overall system and/or only considering one of fan speed and voltage input and output, or may be omitted entirely in some examples. Alternative indicators, such as auditory indicators, or no indicators may be provided in some examples.

The timer and/or the voltage converter may also be omitted in some examples. In such examples less precise diagnostics may be available, and/or mains power may be required for the testing.

In examples, a boost inverter need not necessarily be used. Indeed, in some examples, a

DC/DC voltage converter may be used, which may change the sign of the voltage from negative to positive, and need not necessarily boost the magnitude of the voltage. In examples, a DC/DC voltage converter need not necessarily be used, and the fan may be able to be powered directly by the negative voltage generated across the ramp down load.

It will be appreciated that in some examples a fan or fans need not necessarily be used and that any cooling device (such as a water cooling device or other cooling device) that is configured to cool the ramp down load and configured to be powered by a voltage generated across at least a portion of the ramp down load when current flowing in the electromagnet is passed through the ramp down load may be used. Indeed, in some examples, a fan or fans may not be present and instead another cooling device or devices, such as a water cooling device or devices, configured to cool the ramp down load and configured to be powered by a voltage generated across at least a portion of the ramp down load when current flowing in the electromagnet is passed through the ramp down load may be used.

The above examples are to be understood as illustrative examples of the invention. Other examples are envisaged. It is to be understood that any feature described in relation to any one example may be used alone, or in combination with other features described, and may also be used in combination with one or more features of any other of the examples, or any combination of any other of the examples. Furthermore, equivalents and modifications not described above may also be employed without departing from the scope of the invention, which is defined in the accompanying claims.

Independent of the grammatical term usage, individuals with male, female or other gender identities are included within the term.

## Claims

1. A cooling system for a magnetic resonance imaging, MRI, apparatus, the cooling system comprising:
a ramp down load configured to ramp down current flowing in an electromagnet of the MRI apparatus by dissipating electrical energy in the form of heat; and
at least one cooling device configured to cool the ramp down load;
wherein the at least one cooling device is configured to be powered by a voltage generated across at least a portion of the ramp down load when current flowing in the electromagnet is passed through the ramp down load.

2. A cooling system according to claim 1 wherein the at least one cooling device is at least one fan.

3. A cooling system according to claim 1 or claim 2, comprising a heat sink thermally coupled to the ramp down load, and wherein the at least one cooling device is configured to cool the heat sink.

4. A cooling system according to any one of claims 1 to 3, wherein the cooling system comprises at least one DC/DC voltage converter configured to invert the voltage generated across the at least a portion of the ramp down load to power the at least one cooling device.

5. A cooling system according to any one of claims 1 to 4, wherein the at least a portion of the ramp down load comprises at least one diode configured to, while the current is passed through the at least one diode, dissipate electrical energy in the form of heat and generate the voltage.

6. A cooling system according to any one of claims 1 to 5, wherein the cooling system comprises a monitoring apparatus configured to test the cooling system when no current is being passed through the ramp down load, and an indicator configured to indicate a result of a test of the cooling system undertaken by the monitoring apparatus.

7. A cooling system according to claim 6, wherein the monitoring apparatus comprises: at least one of: a cooling device speed monitor configured to monitor a speed of the at least one cooling device, and a voltage monitor configured to monitor a voltage supplied to the at least one cooling device; and a diagnostic unit configured to receive and evaluate an output from the voltage monitor and/or the cooling device speed monitor to diagnose operation of the at least one cooling device.

8. A cooling system according to any one of claims 6 or 7, wherein the monitoring apparatus is configured to power the at least one cooling device using a different voltage source than the at least a portion of the ramp down load.

9. A cooling system according to claim 8, wherein the monitoring apparatus comprises a voltage converter to convert a positive voltage from the different voltage source to a negative voltage that simulates the voltage generated across the at least a portion of the ramp down load.

10. A cooling system according to any one of claims 6 to 9, wherein the at least one cooling device comprises a plurality of cooling devices, and the monitoring apparatus is configured to test sequentially each of the plurality of cooling devices.

11. A cooling system according to any one of claims 1 to 10, comprising a controller configured to control a switch that when opened causes the current flowing in the electromagnet to pass through the ramp down load, thereby ramping down the current flowing in the electromagnet.

12. A magnetic resonance imaging, MRI, apparatus comprising the cooling system according to any one of claims 1 to 11.

13. A method of cooling a ramp down load of a magnetic resonance imaging, MRI, apparatus, the ramp down load being configured to ramp down current flowing in an electromagnet of the MRI apparatus by dissipating electrical energy in the form of heat; the method comprising:
passing current flowing in the electromagnet through the ramp down load;
using a voltage generated across at least a portion of the ramp down load when the current flowing in the electromagnet is passed through the ramp down load to power at least one cooling device; and
using the at least one cooling device to cool the ramp down load.

14. The method according to claim 13, wherein the method further comprises testing the at least one cooling device when no current is being passed through the ramp down load, wherein the testing comprises:
converting a positive voltage, from a different voltage source than the ramp down load, to a negative voltage that simulates the voltage generated across the at least a portion of the ramp down load; and
using the negative voltage to power the at least one cooling device during testing.

15. The method according to claim 14, wherein there are a plurality of cooling devices and testing the plurality of cooling devices comprises using the negative voltage to sequentially power each cooling device during testing.
